# EUROPÄISCHE PATENTANMELDUNG

(11) **EP 2 365 383 A2**
(43) Veröffentlichungstag der Anmeldung: **14.09.2011**
(21) Anmeldenummer: 10015651.2
(22) Anmeldetag: 15.12.2010
(51) Int. Cl.: G02F 1/133, G02F 1/1335, H01L 31/00, G06F 1/16

(54) **Bildschirmeinheit mit integrierter Energieerzeugung**

(30) Priorität: 19.12.2009 DE 202009017277 U
(71) Anmelder: Hannemann, Achim, 63791 Karlstein (DE)
(72) Erfinder: Hannemann, Achim, 63791 Karlstein (DE)

(57) **Zusammenfassung**

Die Erfindung bezieht sich Bildschirmeinheit (10), umfassend ein lichtemittierendes Display (12) wie LC-Display sowie eine Solarzellenanordnung (14, 34, 38, 48) zur Versorgung zumindest des Displays (12) mit elektrischer Energie. Um eine Bildschirmeinheit mit integrierter Energieerzeugung und transreflektivem LCD-Display zu ermöglichen, ist vorgesehen, dass das lichtemittierende Display ein transreflektives LC-Display (12) ist und dass die Solarzellenanordnung (14, 34, 38, 48) transparent ausgebildet und integraler Bestandteil einer vor dem LC-Display (12) angeordneten Frontscheibe (14, 30, 36, 44) oder integraler Bestandteil eines frontseitigen Bereichs des LC-Displays (12) ist.

## Beschreibung

Die Erfindung bezieht sich auf eine Bildschirmeinheit mit integrierter Energieerzeugung nach dem Oberbegriff des Anspruchs 1.

Eine derartige Bildschirmeinheit ist in der EP-A-1 187 213 beschrieben. Die Bildschirmeinheit umfasst eine Solarzelle zur Erzeugung elektrischer Energie, welche hinter einem Display-Panel mit lichttransmissiven, lichtemittierenden OLED-Display-Elementen und einem lichttransmissiven Substrat angeordnet ist. Die bekannte Ausführungsform setzt zwingend den Einsatz von lichttransmissiven, lichtemittierenden OLED-Display-Elementen voraus, da nur so gewährleistet ist, dass die hinter dem OLED-Display angeordnete Solarzelle einfallendes Licht empfängt.

In DE-A-102 58 712 ist ein Bauelement für ein Aktiv-Matrix-OLED-Display mit integrierter Energieerzeugung beschrieben, welches einen besonders niedrigen Energieverbrauch aufweist. Bei dieser Ausführungsform teilen sich ein Aktiv-Matrix-OLED-Display und eine Solarzelle dasselbe Substrat und liegen nicht als getrennte Bauelemente vor. Dabei wird eine Solarzelle in ein Bauelement für ein Aktiv-Matrix-OLED-Display integriert, welches aus einem Substrat, einer Anode, anorganischem Emittermaterial, einer Kathode und Komponenten zur aktiven Ansteuerung besteht.

Davon ausgehend liegt der vorliegenden Erfmdung die Aufgabe zu Grunde, eine Bildschirmeinheit der eingangs genannten Art derart weiterzubilden, dass der Einsatz transreflektiver LCD-Displays ermöglicht wird.

Die Aufgabe wird erfindungsgemäß im Wesentlichen dadurch gelöst, dass die Solarzellenanordnung transparent ausgebildet und integraler Bestandteil einer vor dem Display angeordneten Frontscheibe oder integraler Bestandteil des frontseitigen Bereichs des Displays ist.

Gemäß der Erfindung weist die Bildschirmeinheit eine Frontscheibe auf, die derart ausgebildet ist, dass diese zur Stromerzeugung genutzt wird. Dadurch eröffnet sich die Möglichkeit, tageslichttaugliche LCD-Displays, insbesondere transreflektive LCD-Displays autark, d. h. ohne externe Energieversorgung zu betreiben.

Eine bevorzugte Ausführungsform zeichnet sich dadurch aus, dass die Frontscheibe selbst aus transparenten Solarzellen ausgebildet ist.

Alternativ besteht die Möglichkeit, die Frontscheibe laminar auszubilden, wobei eine Solarzellen-Folie wie CIGS-Folie zwischen einer Vorder- und Rückscheibe der Frontscheibe laminiert ist.

Auch besteht die Möglichkeit, die Frontscheibe aus Glas herzustellen, wobei eine Vorderseite und/oder Rückseite mit Dünnschicht-Solarzellen beschichtet ist. Dadurch hat die Frontscheibe die Funktion einer Mehrschicht-Solarzelle, wodurch der Wirkungsgrad erhöht wird.

Die Solarzellen können beispielsweise als amorphe Siliziumsolarzellen, metamorphe Solarzellen, organische Solarzellen, CIGS-Folien, Silikon-Solarzellen, Nano-Solarzellen, Hybrid-Solarzellen, N-Typ-Silicium- oder Kohlenstoff-Nanoröhrchen-Solarzellen und/oder mit transparenten P-Leitern mit ausreichender Leitfähigkeit beschichtet sein.

Die Hybrid-Solarzellen können als hybride Solarzellen mit selbstorganisierenden biometrischen Antennen ausgebildet sein, welche Chlorosomen nachahmen, um bei schwacher Beleuchtung möglichst guten Wirkungsgrad zu erreichen.

Gemäß einer weiteren bevorzugten Ausführungsform ist vorgesehen, dass die Solarzellen Silber-Nanopartikel aufweisen, welche zur Erhöhung der Lichtsammelkomplexe beitragen, so dass die Lichtaufnahmefähigkeit des Systems verbessert wird.

Vorzugsweise sind die Solarzellen perforiert, beispielsweise durch Streifen oder Durchbrechungen wie Löcher, in einer Größe, die vom Auge nicht mehr als störend empfunden wird.

Weitere Einzelheiten, Vorteile und Merkmale der Erfindung ergeben sich nicht nur aus den

Ansprüchen, den diesen zu entnehmenden Merkmalen -für sich und/oder in Kombination-, sondern auch aus der nachfolgenden Beschreibung von den Zeichnungen zu entnehmenden bevorzugten Ausführungsformen.

### Es zeigen:

- Fig. 1: eine schematische Darstellung einer Bildschirmeinheit mit integrierter Energieversorgung,
- Fig. 2a: eine erste Ausführungsform einer Frontscheibe der Bildschirmeinheit,
- Fig. 2b: eine zweite Ausführungsform einer Frontscheibe und
- Fig. 2c: eine dritte Ausführungsform einer Frontscheibe.

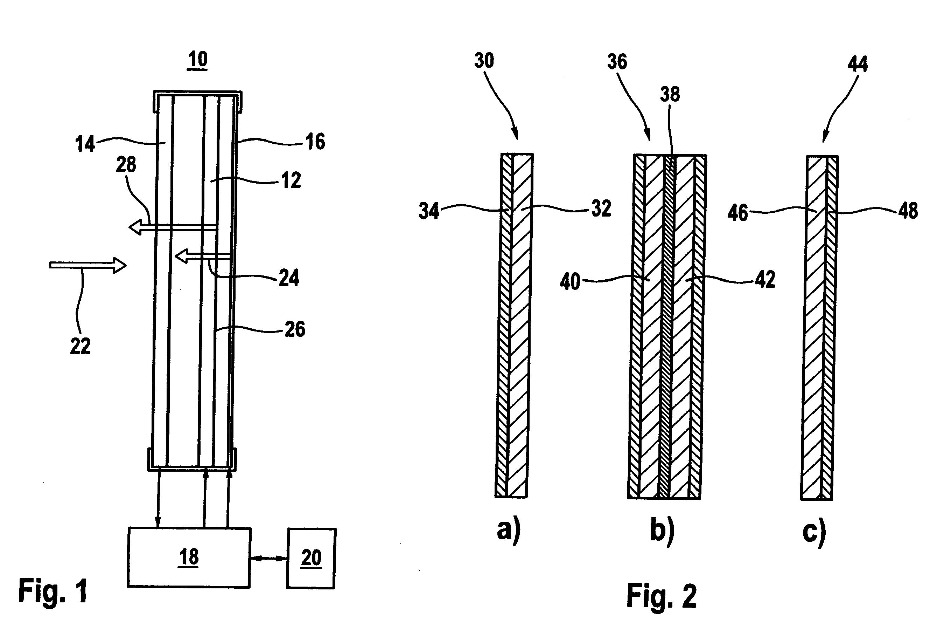

Fig. 1 zeigt rein schematisch einen Aufbau einer Bildschirmeinheit 10 in Seitenansicht, umfassend ein lichtemittierendes, transreflektives LC-Display 12, welches zwischen einer Frontscheibe 14 und ggfs. einem Backlight-Panel 16 angeordnet ist. Gemäß der Erfindung ist die Frontscheibe 14 als transparente, energieerzeugende Solarzellenanordnung ausgebildet. Diese ist mit einer Energieversorgungseinheit 18 verbunden, welche mit einem Energiespeicher 20 wie Akkumulator oder Kondensator gekoppelt ist. Über den Energiespeicher 20 und die Energieversorgungseinheit 18 werden das LC-Display 12 sowie das Backlight-Panel 15 mit Energie versorgt.

Das tageslichttaugliche LC-Display 12 ist derart ausgebildet, dass es auch bei direktem Sonnenlicht 22 kontrastreiche Bilder, entweder statisch oder dynamisch als Farb- oder Schwarz-Weiß-Bilder anzeigt. Durch das einfallende Sonnen- bzw. Tagelicht 22 kann das LC-Display 12 und ggfs. das Backlight-Panel 16 ohne externe Energieversorgung betrieben werden.

Bei der Ausführungsform als transreflektives LC-Display 12 wird zusätzlich zu von dem Backlight-Panel 16 erzeugten Backlight 24 einfallendes Sonnenlicht 22 genutzt. Das Sonnenlicht 22 durchscheint das LC-Display 12 und wird durch einen auf der Rückseite des LC-Displays angeordneten Spiegel 26 reflektiert und als zusätzlicher Lichtstrahl 28 zum Durchleuchten des LC-Displays genutzt. Das Backlight 24 wird entsprechend eines Bildinhalts und des einfallenden Sonnenlichts 22 hell oder dunkel moduliert.

Fig. 1 zeigt die Frontscheibe 14 als transparente Solarzelle.

Alternativ ist in Fig. 2 a eine Frontscheibe 30 dargestellt, umfassend eine handelsübliche Glasscheibe 32, die vorderseitig mit vorzugsweise Dünnschicht-Solarzellen 34 beschichtet ist.

Eine weitere Ausführungsform einer Frontscheibe 36 ist in Fig. 2b dargestellt. Bei dieser Ausführungsform ist eine Solarfolie 38 wie CIGS-Folie zwischen zwei Glasscheiben 40, 42 laminiert. Vorder- und Rückseite können ebenfalls mit Solarzellen beschichtet sein.

Fig. 2c zeigt eine weitere Ausführungsform 44 einer Frontscheibe, umfassend eine transparente Glasscheibe 46, welche auf einer dem LC-Display 12 zugewandten Seite mit Dünnschicht-Solarzellen 48 beschichtet ist.

Diese Ausführungsform zeichnet sich dadurch aus, dass durch das polarisiert austretende Licht 24 des Backlight-Panels 16 oder das reflektierte Sonnenlicht 28 die Solarzellen 48 auf der Rückseite der Frontscheibe zur Energierückgewinnung benutzt werden können. Dadurch hat die Frontscheibe die Funktion einer Mehrschicht-Solarzelle, wodurch der Wirkungsgrad erhöht wird. Einerseits kann durch die vorderseitige Beschichtung eintreffendes Sonnenlicht in elektrische Energie umgewandelt werden und andererseits durch die Rückbeschichtung durch das transreflektive LC-Display reflektiertes Licht zur Energieerzeugung genutzt werden.

Die Solarzellen 14, 34, 38, 48 weisen einen hohen Wirkungsgrad auf, so dass diese wenig Wärme abgeben. Auch sind diese sehr dünn, d. h., dass die Dicke der Solarzellen im nm-Bereich liegt, so dass Transparenz gewährleistet ist.

Durch die erfindungsgemäße Ausführungsform der Frontscheiben 14, 30, 36, 44 kann das auf die Frontscheibe des LC-Displays auftretende Umgebungslicht 32 doppelt genutzt werden. Einerseits erzeugt das einfallende Licht 22 beim Auftreffen auf die Frontscheibe 14, 30, 36, 44 Energie, welche durch die Energieversorgungseinheit 18 beispielsweise zum Laden des Energiespeichers 20 oder auch zum Betrieb des LC-Displays 12 und des Backlight-Panels 16 verwendet werden kann. Andererseits wird das durch die Solarzellen 14, 34, 38, 48 auf das LC-Display 12 einfallende Licht zur Bilderzeugung und zur Unterstützung des Backlight-Panels 16 mittels der transreflektiven Technik genutzt.

Die über die Solarzellen erzeugte Energie kann in dem Energiespeicher 20 zwischengespeichert werden. Bei fehlender Lichteinstrahlung kann die Bildschirmeinheit 10 somit über den Energiespeicher 20 betrieben werden.

Beispielsweise kann tagsüber bei Nichtbenutzung eines TV's der Energiespeicher 20 aufgeladen werden, so dass der Bildschirm 10 über die in dem Energiespeicher 20 gespeicherte Energie abends betrieben werden kann. Auch kann die Bildschirmeinheit 10 an Orten betrieben werden, in denen außer Licht keine anderen Energielieferanten zur Verfügung stehen.

Es wird die Möglichkeit eröffnet, eine derartige Bildschirmeinheit 10 auch ohne Stromanbindung nur mit natürlicher Energie zu betreiben, um Informationen zu empfangen und zu betrachten.

Anwendungsbereiche für die Bildschirmeinheit 10 sind beispielsweise TV-Geräte in lichtdurchfluteten Zimmern, Info- oder Werbedisplays in hellen Foyers oder Schaufensterbereichen und/oder Anwendungen im Außenbereich.

## Patentansprüche

1. Bildschirmeinheit (10), umfassend ein lichtemittierendes Display (12) wie LC-Display sowie eine Solarzellenanordnung (14, 34, 38, 48) zur Versorgung zumindest des Displays (12) mit elektrischer Energie,
**dadurch gekennzeichnet,**
**dass** das lichtemittierende Display ein transreflektives LC-Display (12) ist und dass die Solarzellenanordnung (14, 34, 38, 48) transparent ausgebildet und integraler Bestandteil einer vor dem LC-Display (12) angeordneten Frontscheibe (14, 30, 36, 44) oder integraler Bestandteil eines frontseitigen Bereichs des LC-Displays (12) ist.

2. Bildschirmeinheit nach Anspruch 1,
**dadurch gekennzeichnet,**
**dass** die Frontscheibe (14) aus transparenten Solarzellen gebildet ist.

3. Bildschirmeinheit nach Anspruch 1 oder 2,
**dadurch gekennzeichnet,**
**dass** die Frontscheibe (30) eine Glasscheibe (32) aufweist, deren Vorderseite und/oder Rückseite mit transparenten Solarzellen (34, 48), vorzugsweise Dünnschicht-Solarzellen beschichtet ist.

4. Bildschirmeinheit nach zumindest einem der vorhergehenden Ansprüche,
**dadurch gekennzeichnet,**
**dass** die Frontscheibe (36) laminiert ausgebildet ist, umfassend eine vordere Scheibe (40) sowie eine Rückscheibe (42), zwischen denen eine Solarzellen-Folie (38) wie CIGS-Folie einlaminiert ist.

5. Bildschirmeinheit nach zumindest einem der vorhergehenden Ansprüche,
**dadurch gekennzeichnet,**
**dass** die Solarzellen (14, 34, 38, 489 als amorphe Silicium-Solarzellen, Silicium-Solarzellen, metamorphe Solarzellen, organische Solarzellen, CIGS-Folien, Silicium-Solarzellen, Nano-Solarzellen, Hybrid-Solarzellen und/oder N-Typ-Silicium- oder Kohlenstoff-Nanoröhrchen-Solarzellen ausgebildet sind.

6. Bildschirmeinheit nach zumindest einem der vorhergehenden Ansprüche,
**dadurch gekennzeichnet,**
**dass** die Hybrid-Solarzellen als hybride Solarzellen mit selbstorganisierenden biometrischen Antennen ausgebildet sind.

7. Bildschirmeinheit nach zumindest einem der vorhergehenden Ansprüche,
**dadurch gekennzeichnet,**
**dass** die Solarzellen (14, 34, 38, 48) Silber-Nanopartikel aufweisen.

8. Bildschirmeinheit nach zumindest einem der vorhergehenden Ansprüche,
**dadurch gekennzeichnet,**
**dass** hinter dem transreflektiven LC-Display (12) ein Backlight-Panel (16) angeordnet ist.
